# EUROPEAN PATENT APPLICATION

(11) **EP 4 644 323 A1**
(43) Date of publication of application: **05.11.2025**
(21) Application number: 23912983.6
(22) Date of filing: 28.12.2023
(51) Int. Cl.: C01B 33/02, C23C 16/44, H01M 4/38, H01M 4/587, H01M 4/02

(54) **SILICON-POLYMER COMPOSITE, PREPARATION METHOD THEREFOR, AND ANODE ACTIVE MATERIAL COMPRISING SAME**

(30) Priority: 29.12.2022 KR 20220188839
(71) Applicant: Hanwha Solutions Corporation, Jung-gu Seoul 04541 (KR); Korea Advanced Institute of Science and Technology, Daejeon 34141 (KR)
(72) Inventor: KIM, Do Heung, Seoul 04541 (KR); JEON, Hyojin, Seoul 04541 (KR); KIM, Eui Duk, Seoul 04541 (KR); PARK, Sarang, Seoul 04541 (KR); IM, Sung Gap, Daejeon 34141 (KR); JANG, Wontae, Daejeon 34141 (KR); CHOI, Keonwoo, Daejeon 34141 (KR); KANG, Minjeong, Daejeon 34141 (KR); JANG, Dawon, Seoul 04541 (KR)
(74) Representative: Berggren Oy
(86) International application number: PCT/KR2023/021865
(87) International publication number: WO 2024/144309

(57) **Abstract**

The present invention relates to a silicon-polymer composite, a preparation method therefor, and an anode active material comprising same. In the silicon-polymer composite according to an embodiment of the present invention, the original shape of silicon particles is preserved because a polymer thin film has excellent thickness uniformity, and the polymer thin film has little impact on electrical conductivity and lithium-ion conductivity, and thus, when the silicon-polymer composite is used as an anode active material, the silicon-polymer composite acts as a stable solid electrolyte interphase layer between silicon and an electrolyte, while still maintaining the high specific power and high Coulombic efficiency of silicon which is the main anode active material. Accordingly, degradation in battery performance and battery lifespan may be suppressed.

## Description

### TECHNICAL FIELD

The present invention relates to a method for preparing a silicon-polymer composite, and more particularly, to a silicon-polymer composite, a preparation method therefor, and an anode active material comprising the same.

### BACKGROUND

With the recent advancement of the information and communication industry, the demand for electronic devices has surged, and as the electric vehicle market continues to grow, the demand for batteries used in these electronic devices and electric vehicles has also significantly increased.

Secondary batteries, such as lithium secondary batteries containing a liquid electrolyte and all-solid-state batteries, are most widely used for such applications because they have high energy density and exhibit a low degree of self-discharge when not in use. Secondary batteries are generally composed of a cathode, an anode, and an electrolyte (either liquid or solid), and carbon-based materials such as graphite are widely used as anode active materials in secondary batteries.

Recent ly, efforts have been made to use silicon-based anode active materials in order to improve the capacity of secondary batteries. Silicon is attracting attention as a next-generation battery anode active material to replace graphite due to its theoretically high energy density. However, during charge and discharge, it reacts with lithium and undergoes a volume expansion of up to approximately 300%, resulting in a significant decrease in mechanical stability, such as the fracturing of the silicon anode active material as the charge-discharge cycles progress.

To address these issues, Japanese Patent No. 4393610 discloses an anode active material in which silicon is composited with carbon through a mechanical processing step, and the surface of silicon particles is coated with a carbon layer using a chemical vapor deposition (CVD) method. However, this approach has limitations in suppressing the volume expansion and contraction that occur during charge and discharge.

In addition, silicon-based anode active materials have a drawback in that, during the pulverization of the silicon raw material, an excessive formation of a solid electrolyte interphase (SEI) layer occurs, which tends to be unstable and leads to deterioration in battery stability and electrical performance.

### DISCLOSURE

### TECHNICAL PROBLEM

The present invention is directed to providing a silicon-polymer composite in which a polymer thin film exhibits excellent thickness uniformity, thereby preserving the original shape of silicon particles and suppressing degradation in battery performance and lifespan when used as an anode active material.

The present invention is also directed to providing a method for preparing the above-described silicon-polymer composite.

The present invention is also directed to providing an anode active material comprising the above-described silicon-polymer composite.

### TECHNICAL SOLUTION

The present invention provides a method for preparing a silicon-polymer composite, the method including forming a polymer thin film on surfaces of silicon particles by initiator-based chemical vapor deposition (iCVD).

According to an embodiment of the present invention, the forming a polymer thin film may include (1) supplying silicon particles into a reactor; (2) supplying a monomer and an initiator into the reactor in which the silicon particles have been supplied; and (3) forming the polymer thin film on surfaces of the silicon particles by polymerizing the monomer through activation of the initiator.

In addition, the silicon particles may be non-porous silicon particles.

In addition, the silicon particles may have an average particle diameter in the range of 10 nm to 50 µm.

In addition, the polymer thin film may have a thickness in the range of 1 nm to 10 µm.

In addition, in step (2), the monomer may be supplied at a flow rate in the range of 0.1 sccm to 10 sccm, and the initiator may be supplied at a flow rate in the range of 0.1 sccm to 5 sccm.

In addition, the initiator may be activated through predetermined heat treatment, and the heat treatment may be performed at a temperature in the range of 135°C to 350°C.

In addition, step (3) may be performed under a vacuum at a pressure in the range of 50 to 1,000 mTorr for a duration of 10 minutes to 6 hours.

In addition, the method may further include forming a carbon thin film on the surface of the polymer thin film after forming the polymer thin film.

In addition, the carbon thin film may have a thickness in the range of 1 nm to 1 µm.

In addition, the present invention provides a silicon-polymer composite prepared by the above-described method for preparing a silicon-polymer composite.

In addition, the present invention provides an anode active material comprising the above-described silicon-polymer composite and a carbon-based anode material.

In addition, the present invention provides an all-solid-state battery comprising a solid electrolyte interphase (SEI) layer that comprises the above-described silicon-polymer composite.

### ADVANTAGEOUS EFFECT

In the silicon-polymer composite according to an embodiment of the present invention, the original shape of silicon particles is preserved because a polymer thin film has excellent thickness uniformity, and the polymer thin film has little impact on electrical conductivity and lithium-ion conductivity, and thus, when the silicon-polymer composite is used as an anode active material, the silicon-polymer composite acts as a stable solid electrolyte interphase layer between silicon and an electrolyte, while still maintaining the high specific power and high Coulombic efficiency of silicon which is the main anode active material. Accordingly, degradation in battery performance and battery lifespan may be suppressed.

### BRIEF DESCRIPTION OF THE DRAWINGS

FIG. 1 is a schematic view illustrating a process of forming a polymer thin film on the surface of a silicon particle by an initiator-based chemical vapor deposition (iCVD) process according to an embodiment of the present invention.
FIG. 2 is a TEM image of a bare silicon particle before a polymer thin film is formed on the surface of the silicon particle according to an embodiment of the present invention.
FIG. 3 is a photograph showing the degree of dispersion of particles in water before and after a polymer thin film is formed on the surface of silicon particles (Example 1) according to an embodiment of the present invention.
FIG. 4 is a TEM image of a silicon-polymer composite (Example 1) according to an embodiment of the present invention.
FIG. 5 is an energy-dispersive spectroscopy (EDS) image of a silicon-polymer composite according to an embodiment of the present invention.
FIG. 6 is a TEM image of a silicon-polymer composite (Example 2) according to an embodiment of the present invention.
FIG. 7 is a graph comparing the nitrogen atom content between bare silicon particles and a silicon-polymer composite (Example 2) according to an embodiment of the present invention.
FIG. 8 is a TEM image of a silicon-polymer composite (Example 3) according to an embodiment of the present invention.
FIG. 9 is a TEM image of a silicon-polymer composite (Example 4) according to an embodiment of the present invention.
FIG. 10 is a TEM image of bare silicon particles, a silicon-polymer composite (Example 4) according to an embodiment of the present invention, and a silicon-polymer composite prepared by performing polymer coating in a liquid phase (Comparative Example 1).
FIG. 11 is a graph showing the initial charge/discharge efficiency and capacity retention of a battery using bare silicon particles and a battery (Preparation Example 1) using a silicon-polymer composite (Example 1) according to an embodiment of the present invention.

### BEST MODES FOR CARRYING OUT THE INVENTION

The present invention is not limited to the embodiments disclosed below, and may be modified in various forms as long as the spirit of the invention is not altered.

In the present specification, the terms "comprise" or "include" mean that other components may be further included unless otherwise specified.

Unless otherwise specified, all numerical values and expressions indicating the amounts of components, reaction conditions, and the like described in the present specification are to be understood as being modified by the term "about" in all instances.

In the present specification, when one component is described as being formed on, under, connected to, or coupled with another component, such descriptions are intended to include both direct formation, connection, or coupling between the components and indirect formation, connection, or coupling via another component.

Hereinafter, the present invention will be described in more detail.

### Silicon-polymer composite

The present invention provides a silicon-polymer composite prepared by a method for preparing a silicon-polymer composite, which will be described below. The silicon-polymer composite is implemented to include silicon particles and a polymer thin film formed on the surface of the silicon particles.

### Silicon particles

The silicon-polymer composite according to an embodiment of the present invention includes silicon particles.

Since the silicon particles serve to store lithium, when the silicon-polymer composite according to an embodiment of the present invention is used as an anode active material, the silicon particles may function as a main anode active material.

The silicon particles may be at least one selected from porous silicon particles and non-porous silicon particles, but may be preferably non-porous silicon particles. Accordingly, the polymer thin film may exhibit excellent thickness uniformity, allowing the original shape of the silicon particles to be preserved, and may be more advantageous in terms of suppressing degradation in battery performance and lifespan when used as an anode active material.

In addition, the silicon particles may be crystalline or amorphous, and from the perspective of expansion/contraction during charge and discharge of a secondary battery and overall battery performance, they may be preferably amorphous or in a similar phase. When the silicon particles are crystalline, a smaller crystallite size allows for the formation of a denser composite, thereby enhancing the strength of the matrix and preventing cracking. Accordingly, the initial efficiency and cycle life characteristics of the secondary battery may be improved. Meanwhile, when the silicon particles are amorphous or in a similar phase, the expansion or contraction during charge and discharge of the secondary battery may be reduced, and battery performance such as capacity characteristics may be improved.

The size of the silicon particles may be selected to be suitable for the silicon-polymer composite according to an embodiment of the present invention to be used as an anode active material. Specifically, the silicon particles may have an average particle diameter of 10 nm to 50 µm, and preferably 10 nm to 25 µm. As the silicon particles satisfy the above average particle diameter range, they may be more advantageous in achieving the objectives of the present invention.

The silicon particles may further include a silicon oxide compound. The silicon oxide compound may be represented by the general formula SiOx, where 0.5 ≤ x ≤ 2. Here, when the value of x is less than 0.5, expansion and contraction during charge and discharge of the secondary battery may become significant, leading to deterioration in lifespan characteristics. When x exceeds 2, the amount of inactive oxide increases, which may result in a decrease in the initial efficiency of the secondary battery.

The content of the silicon oxide compound in the silicon particles may be 50 wt% or less based on the total weight of the silicon particles. When the content of the silicon oxide compound in the silicon particles exceeds 50 wt%, the initial efficiency of the secondary battery may deteriorate.

The silicon particles may further include elements such as carbon or magnesium in addition to silicon and oxygen, but the silicon content in the silicon particles may be selected such that the total silicon content in the silicon-polymer composite is 1 to 80 wt%, and preferably 5 to 50 wt%. When the total silicon content in the silicon-polymer composite is less than 1 wt%, the amount of active material capable of absorbing and releasing lithium may be insufficient, which may lead to a reduction in the charge/discharge capacity of the secondary battery. When the total silicon content in the silicon-polymer composite exceeds 80 wt%, the charge/discharge capacity of the secondary battery may increase; however, the expansion and contraction of the electrode during charge and discharge may become excessive, and the anode active material powder may become further pulverized, which may lead to deterioration in the cycle characteristics of the secondary battery.

### Polymer thin film

The silicon-polymer composite according to an embodiment of the present invention includes a polymer thin film formed on the surface of the silicon particles.

In the silicon-polymer composite according to an embodiment of the present invention, the polymer thin film on the surface of the silicon particles is formed by an initiator-based chemical vapor deposition (iCVD) process, which will be described below.

The polymer thin film is formed by iCVD, and the type of material is not particularly limited as long as it has little effect on the electrical conductivity and lithium-ion conductivity of the anode active material. Specifically, the polymer thin film may be formed by polymerization or copolymerization of one or more vinyl or acrylate monomers containing one or more of a siloxane group, an amine group, a fluorine group, a glycidyl group, and an aromatic hydrocarbon group.

In a specific embodiment of the present invention, the polymer thin film may be formed by polymerization of one or more monomers selected from the group consisting of: 4-vinyl pyridine (4VP); 2,4,6,8-tetramethyl-2,4,6,8-tetravinylcyclotetrasiloxane; 3,3,4,4,5,5,6,6,7,7,8,8,9,9,10,10,10-heptadecafluorodecyl methacrylate (PFDMA); 1,3,5,7-tetravinyl-1,3,5,7-tetramethylcyclotetrasiloxane (V4D4); 1,3,5-trimethyl-1,3,5-trivinylcyclotrisiloxane (V3D3); hexavinyldisiloxane (HVDS); glycidyl methacrylate; divinylbenzene; diethyleneglycol divinyl ether; diethyleneglycol diacrylate (DEGDA); ethylene glycol dimethacrylate; dimethylaminoethyl methacrylate; methacrylic acid; 1,3-diethenyl-1,1,3,3-tetramethyldisiloxane; 1H,1H,2H,2H-perfluorodecyl acrylate; perfluorodecyl methacrylate; dodecafluoroheptyl acrylate; pentafluorophenyl methacrylate; 3,3,4,4,5,5,6,6,7,7,8,8,9,9,9-pentadecafluorononyl acrylate; 2-methyl-3,3,4,4,5,5,6,6,7,7,8,8,9,9,9-pentadecafluorononyl acrylate; 3,3,4,4,5,5,6,6,7,7,8,8,8-tridecafluorooctyl acrylate; 2-methyl-3,3,4,4,5,5,6,6,7,7,8,8,8-tridecafluorooctyl acrylate; 3,3,4,4,5,5,6,6,7,7,7-undecafluoroheptyl acrylate; 2-methyl-3,3,4,4,5,5,6,6,7,7,7-undecafluoroheptyl acrylate; 3,3,4,4,5,5,6,6,6-nonafluorohexyl acrylate; 2-methyl-3,3,4,4,5,5,6,6,6-nonafluorohexyl acrylate; 3,3,4,4,5,5,6,6,7,7,8,8,9,9,10,10,11,11,11-nonadecafluoroundecyl acrylate; 2-methyl-3,3,4,4,5,5,6,6,7,7,8,8,9,9,10,10,11,11,11-nonadecafluoroundec yl acrylate; 3,3,4,4,5,5,6,6,7,7,8,8,9,9,10,10,11,11,12,12,12-heneicosafluorododecyl acrylate; 2-methyl-3,3,4,4,5,5,6,6,7,7,8,8,9,9,10,10,11,11,12,12,12-heneicosafluo rododecyl acrylate; 3,3,4,4,5,5,6,6,7,7,8,8,9,9,10,10,11,11,12,12,13,13,13-tricosafluorotri decyl acrylate; 2-methyl-3,3,4,4,5,5,6,6,7,7,8,8,9,9,10,10,11,11,12,12,13,13,13-tricosa fluorotridecyl acrylate; 3,3,4,4,5,5,6,6,7,7,8,8,9,9,10,10,11,11,12,12,13,13,14,14,14-pentacosaf luorotetradecyl acrylate; 2-methyl-3,3,4,4,5,5,6,6,7,7,8,8,9,9,10,10,11,11,12,12,13,13,14,14,14-p entacosafluorotetradecyl acrylate; dimethylaminoethyl methacrylate; dimethylaminoethyl acrylate; diethylaminoethyl methacrylate; and diethylaminoethyl acrylate.

In a preferred embodiment of the present invention, the polymer thin film may be formed by polymerization of one or more monomers selected from the group consisting of 1H,1H,2H,2H-perfluorodecyl acrylate, dimethylaminomethyl styrene, divinylbenzene, glycidyl methacrylate, 1,3,5,7-tetravinyl-1,3,5,7-tetramethylcyclotetrasiloxane, 1,3,5-trimethyl-1,3,5-trivinylcyclotrisiloxane, and hexavinyldisiloxane, but is not limited thereto.

In a specific embodiment of the present invention, the thickness of the polymer thin film may be from 1 nm to 10 µm, preferably from 1 nm to 1 µm, and more preferably from 10 to 100 nm. When the thickness of the polymer thin film is within this range, it may have little effect on the electrical conductivity and lithium-ion conductivity of the anode active material, while acting as a stable solid electrolyte interphase layer between the silicon and the electrolyte, thereby suppressing degradation in battery lifespan.

### Carbon thin film

The silicon-polymer composite according to an embodiment of the present invention may further include a carbon thin film formed on the surface of the polymer thin film, thereby forming a silicon-polymer-carbon composite.

When the silicon-polymer composite according to an embodiment of the present invention further includes a carbon thin film to form a silicon-polymer-carbon composite, the resulting silicon-polymer-carbon composite may secure appropriate electrical conductivity and allow for suitable adjustment of its specific surface area, thereby further improving the cycle characteristics and capacity of the secondary battery when used as an anode active material.

The electrical conductivity of the anode active material is an important factor that facilitates electron transfer during electrochemical reactions. If the silicon-polymer composite used as an anode active material contains an insufficient amount of carbon, the electrical conductivity of the anode activematerial may not be sufficient. In this case, by additionally forming a carbon thin film on the surface of the silicon-polymer composite to prepare a silicon-polymer-carbon composite, it is possible to improve the charge/discharge capacity, initial charge efficiency, and capacity retention of the secondary battery, provide excellent electrical conductivity, suppress side reactions with the electrolyte, and further enhance the performance of the secondary battery.

In the silicon-polymer-carbon composite according to an embodiment of the present invention, the thickness of the carbon thin film may be from 1 nm to 1 µm, preferably from 3 to 150 nm, and more preferably from 5 to 100 nm. When the thickness of the carbon thin film is within this range, it is possible to achieve an improvement in conductivity while suppressing a decrease in the capacity of the secondary battery.

The carbon thin film may include one or more selected from graphene, carbon nanotubes, carbon nanofibers, and graphite. Specifically, the carbon thin film may include graphene and may further include graphite, but is not limited thereto.

### Method for Preparing Silicon-Polymer Composite

The silicon-polymer composite according to an embodiment of the present invention is prepared by a method comprising a step of forming a polymer thin film on the surface of silicon particles through an initiator-based chemical vapor deposition (iCVD) process.

The initiator-based chemical vapor deposition (iCVD) refers to a process in which a vapor-phase initiator is decomposed into radicals to polymerize monomers. Although the initiator-based chemical vapor deposition (iCVD) process involves supplying energy using a heat source such as a heated filament or ultraviolet (UV) light to induce the deposition of a polymer thin film-seemingly similar to conventional CVD processes for depositing inorganic thin films-the iCVD process activates the initiator at a relatively low temperature range of 135 to 350°C, and preferably 140 to 340°C. In addition, the surface temperature of the silicon particles on which the polymer thin film is deposited is maintained at a low range of 10 to 50°C, and preferably 13 to 45°C. Due to such a low surface temperature, iCVD can be usefully appl ied to deposit polymer thin films on various substrates that are vulnerable to mechanical or chemical stress. In addition, since the iCVD process is carried out under a vacuum condition in the range of 50 to 1,000 mTorr, and preferably 60 to 900 mTorr, high-vacuum equipment is not required.

Meanwhile, according to an embodiment of the present invention, the step of forming the polymer thin film may include: (1) supplying silicon part icles into a reactor; (2) supplying a monomer and an initiator into the reactor containing the silicon particles; and (3) forming a polymer thin film on the surface of the silicon particles by activating the initiator to polymerize the monomer.

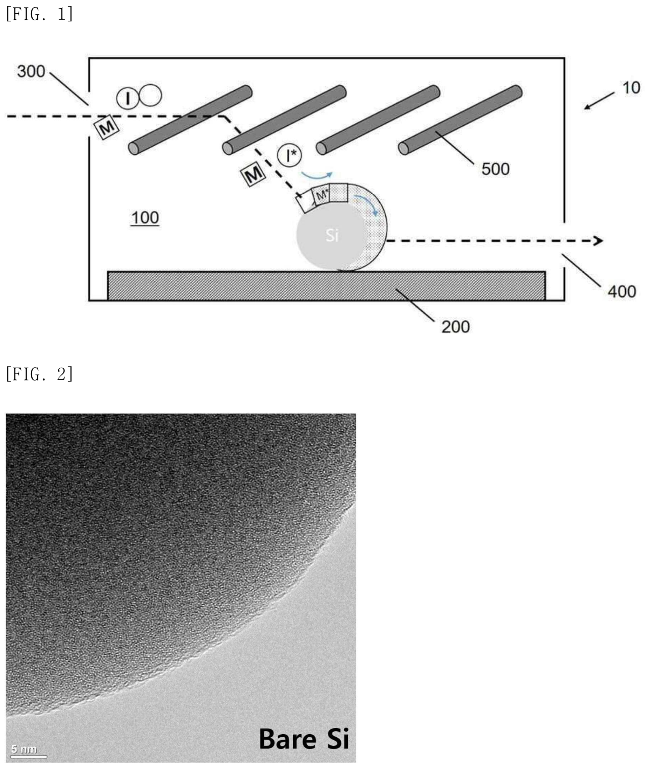

FIG. 1 is a schematic view illustrating a process of forming a polymer thin film on the surface of a silicon particle by an initiator-based chemical vapor deposition (iCVD) process according to an embodiment of the present invention. A method for preparing a silicon-polymer composite according to an embodiment of the present invention will now be described with reference to FIG. 1.

### Step (1)

In step (1), silicon particles are supplied into the reactor.

In the method for preparing a silicon-polymer composite according to an embodiment of the present invention, the structure of the reactor is not particularly limited as long as it is capable of forming a polymer thin film on the surface of silicon particles using an initiator-based chemical vapor deposition (iCVD) process, which will be described below.

In a specific embodiment of the present invention, the reactor 10 may include a chamber 100, a mounting unit 200, an inlet 300, an outlet 400, and a heating unit 500.

The silicon particles may be placed on the mounting unit 200 provided at the bottom of the chamber 100 of the reactor 10. The shape, size, and material of the mounting unit are not particularly limited as long as it is capable of accommodating the silicon particles. Specifically, the mounting unit may have a flat-plate shape that allows the silicon particles to be spread out and arranged so as not to overlap with one another as much as possible. More specifically, a silicon substrate (wafer) may be used as the mounting unit for accommodating the silicon particles, but is not limited thereto.

The mounting unit may be connected to a position-adjusting means (not shown) capable of changing the position of the silicon particles. The position-adjusting means may, for example, vibrate or move the mounting unit, which is a silicon substrate, to change or rotate the positions of the silicon particles placed on the silicon substrate, thereby allowing a polymer thin film to be uniformly formed on the surface of the silicon particles in the subsequent step (3), but is not limited thereto.

### Step (2)

In step (2), the monomer and the initiator are supplied into the reactor.

At this time, the monomer (M) and the initiator (I) may be vaporized and supplied into the chamber 100 of the reactor 10 through the inlet 300.

The monomer (M) is a volatile substance that can be activated by the initiator (I) to form a polymer. Details of the monomer are as described above in the section on the silicon-polymer composite.

The initiator (I) is a substance that forms free radicals upon decomposition by heat or light, and as long as it is capable of activating the monomer to form a polymer, its type is not particularly limited. Preferably, the initiator may be a peroxide. Specifically, the initiator may include at least one selected from the group consisting of di-t-butyl peroxide, t-butyl peroxybenzoate, benzoyl peroxide, methyl ethyl ketone peroxide, lauryl peroxide, and benzophenone, but is not limited thereto. Most preferably, the initiator may be di-t-butyl peroxide.

At this time, the flow rate of the monomer in the reactor may be from 0.1 sccm to 10 sccm. Specifically, the monomer flow rate may be 0.1 sccm or more, or 0.2 sccm or more, and 10 sccm or less, 5 sccm or less, or 4 sccm or less.

In addition, the flow rate of the initiator in the reactor may be from 0.1 sccm to 5 sccm. Specifically, the initiator flow rate may be 0.1 sccm or more and 5 sccm or less, 3 sccm or less, or 2 sccm or less.

### Step (3)

In step (3), the initiator is activated to polymerize the monomer, thereby forming a polymer thin film on the surface of the silicon particles.

First, the initiator (I) supplied in a vaporized state into the chamber 100 of the reactor 10 is act ivated by coming into contact with the heating unit 500, thereby forming free radicals (I*). The heating unit may be, for example, a plurality of filaments heated by electricity, but is not limited thereto. The temperature of the heating unit is not limited as long as it is sufficient to decompose and activate the initiator, but is preferably in the range of 135 to 350°C, and more preferably in the range of 140 to 340°C, which may be advantageous in terms of preventing changes in the properties of the reactants.

The free radicals (I*) generated from the initiator and the monomer (M) move downward within the chamber and are adsorbed onto the surface of the silicon particles accommodated on the mounting unit 200. The monomer adsorbed on the surface of the silicon particles is activated (M*) by the free radicals (I*), and polymerization proceeds to form a polymer thin film on the surface of the silicon particles.

The initiator and monomer remaining in the vapor phase after being used in the reaction of step (3) may be discharged out of the reactor through the outlet 400.

In step (3), it is preferable to maintain the surface temperature of the silicon particles at a low level in order to increase the adsorption rate of the monomer and the free radicals. Specifically, the surface temperature of the silicon particles is preferably in the range of 10 to 50°C, and more preferably in the range of 13 to 45°C, but is not particularly limited to these ranges. To maintain the surface temperature of the silicon particles within the above range, the reactor 10 may further include a cooling unit (not shown) disposed below the mounting unit 200. The cooling unit (not shown) is not particularly limited in terms of its cooling method or structure, as long as it is capable of controlling the surface temperature of the silicon particles within the above range.

Step (3) may be carried out under a vacuum condition in the range of 50 to 1,000 mTorr, and preferably in the range of 60 to 900 mTorr. Such a vacuum range can be achieved using a simple rotary pump rather than a high-vacuum pump. In addition, step (3) may be carried out for a reaction time of 10 minutes to 6 hours, and preferably 30 minutes to 2 hours, but is not limited thereto. However, when the reaction time satisfies the above time range, a polymer thin film having the desired thickness can be uniformly formed.

The physical properties of the polymer thin film formed in step (3) can be easily controlled by adjusting the process parameters of the iCVD. That is, by controlling variables such as the pressure and temperature inside the chamber, the reaction time, the flow rates of the initiator and the monomer, and the temperatures of the heating unit and the surface of the silicon particles, the molecular weight, thickness, composition, and deposition rate of the polymer thin film can be easily adjusted.

### Additional step(s)

The method for preparing a silicon-polymer composite according to an embodiment of the present invention may further include a step of forming a carbon thin film on the surface of the polymer thin film after the step of forming the polymer thin film.

The step of forming a carbon thin film on the surface of the polymer thin film of the silicon-polymer composite may be performed using devices and methods known in the technical field of the present invention, such as chemical pyrolysis deposition, but is not particularly limited thereto.

In a specific embodiment of the present invention, the step of forming a carbon thin film on the surface of the polymer thin film of the silicon-polymer composite may be performed by heat-treating the silicon-polymer composite at a temperature of 400 to 1,200°C in the presence of a gaseous carbon source.

In a preferred embodiment of the present invention, the carbon source may include at least one selected from the group consisting of methane, ethane, propane, butane, methanol, ethanol, propanol, propanediol, butanediol, ethylene, propylene, butylene, butadiene, cyclopentene, acetylene, benzene, toluene, xylene, ethylbenzene, naphthalene, anthracene, and dibutylhydroxytoluene, but is not limited thereto.

The step of forming a carbon thin film on the surface of the polymer thin film of the silicon-polymer composite may be performed in the presence of at least one inert gas selected from the group consisting of hydrogen, nitrogen, helium, and argon, in addition to the above carbon sources.

The reaction time (heat treatment time) for forming the carbon thin film can be appropriately adjusted depending on the heat treatment temperature, the pressure during heat treatment, the composition of the gas mixture, and the desired amount of carbon coating. For example, the reaction time may be from 10 minutes to 100 hours, specifically from 30 minutes to 90 hours, and more specifically from 50 minutes to 40 hours, but is not particularly limited to these ranges.

In a specific embodiment of the present invention, the step of forming a carbon thin film on the surface of the polymer thin film of the silicon-polymer composite may be performed by mixing the silicon-polymer composite with a solution in which a carbon source is dispersed in a solvent as needed, followed by drying and heat treatment at a temperature of 400 to 1,400°C.

In a preferred embodiment of the present invention, the carbon source may be selected from the group consisting of pitch, hydrocarbon-based substances, and petroleum-based substances. More specifically, the pitch may be petroleum-based pitch, coal-based pitch, or a mixture thereof; the hydrocarbon-based substance may be furfuryl alcohol or a phenolic resin; and the petroleum-based substance may be pyrolysis fuel oil (PFO), naphtha cracking bottom oil (NCB), ethylene cracker bottom oil (EBO), vacuum residue (VR), de-asphalted oil (DAO), atmospheric residue (AR), fluid catalytic cracking decant oil (FCC-DO), residue fluid catalytic cracking decant oil (RFCC-DO), or heavy aromatic oil. The solvent may be tetrahydrofuran (THF) or an alcohol.

By the carbon thin film formation step, a silicon-polymer-carbon composite in which a carbon thin film is uniformly formed over the entire surface of the polymer thin film of the silicon-polymer composite can be obtained. When forming the carbon thin film on the surface of the polymer thin film of the silicon-polymer composite, it is possible to form the carbon thin film on the surface without substantially damaging the polymer thin film by appropriately adjusting factors such as the type of monomer, the process conditions during the formation of the polymer thin film, the type of carbon source, and the process conditions during the formation of the carbon thin film. That is, when forming the carbon thin film on the surface of the polymer thin film of the silicon-polymer composite, 10 to 100 wt%, preferably 50 to 100 wt%, and more preferably 80 to 100 wt% of the polymer thin film may remain on the surface of the silicon particles. When the resulting silicon-polymer-carbon composite is used as an anode active material, the electrical conductivity of the anode active material can be improved without structural changes.

In the method for preparing a silicon-polymer composite or a silicon-polymer-carbon composite according to an embodiment of the present invention, the resulting silicon-polymer composite or silicon-polymer-carbon composite may be crushed or pulverized and classified. Through classification, the particle size distribution of the composite can be made uniform. The classification may be performed by dry classification, wet classification, or classification using a sieve.

### Anode active material

According to another embodiment of the present invention, an anode active material comprising the silicon-polymer composite is provided.

The anode active material according to an embodiment of the present invention may further include a carbon-based anode material, specifically a graphite-based anode material, in addition to the silicon-polymer composite or the silicon-polymer-carbon composite. For example, the anode active material may be obtained by mixing the silicon-polymer composite or the silicon-polymer-carbon composite according to an embodiment of the present invention with a carbon-based anode material, such as a graphite-based anode material.

Here, the carbon-based anode material may include at least one selected from the group consisting of natural graphite, artificial graphite, soft carbon, hard carbon, mesocarbon, carbon fibers, carbon nanotubes, pyrolytic carbon, cokes, calcined products of organic polymer compounds, and carbon black, but is not particularly limited thereto.

The content of the carbon-based anode material in the anode active material according to an embodiment of the present invention may be 2 to 80 wt%, preferably 5 to 70 wt%, and more preferably 30 to 70 wt%, based on the total weight of the anode active material.

The anode active material according to an embodiment of the present invention can be effectively used for manufacturing anodes of secondary batteries, specifically anodes of lithium secondary batteries and all-solid-state batteries.

### All-solid-state battery

According to another embodiment of the present invention, an all-solid-state battery comprising an SEI (Solid Electrolyte Interphase) layer including the silicon-polymer composite is provided.

The all-solid-state battery may be an all-solid-state battery including a cathode, an anode, and a solid electrolyte interposed between the cathode and the anode. The anode may include an anode active material layer, and the anode active material layer may include an SEI (Solid Electrolyte Interphase) layer comprising the above-described silicon-polymer composite on at least a portion of the surface of the anode active material particles.

Meanwhile, the anode active material particles may be carbon-based anode materials, and in this case, the description may be the same as that provided above with respect to the anode active material; therefore, a detailed description thereof will be omitted.

In addition, aside from the anode active material particles and the SEI layer of the all-solid-state battery, the anode configuration, cathode configuration, and solid electrolyte configuration may be based on those of known all-solid-state batteries, and thus are not particularly limited in the present invention.

### MODE FOR CARRYING OUT THE INVENTION

### Examples

The present invention will now be described in more detail with reference to the following examples. The following examples are provided merely for illustrative purposes and are not intended to limit the scope of the present invention.

### <Example 1>

### Preparation of Silicon-Polymer Composite

A silicon-polymer composite was prepared using the reactor schematically illustrated in FIG. 1. Silicon powders having average particle diameters of 20 µm and 2 µm, respectively, were each evenly spread and placed on a circular silicon wafer in an amount of 5 g. A vaporized monomer and initiator were supplied into the reactor chamber through the inlet to form a polymer thin film (pPFDA) on the surface of the silicon particles. The specific materials and process conditions used in Example 1 are as follows.
- Non-porous silicon particles: average particle diameters of 20 µm and 2 µm (REC Silicon)
- Monomer: 1H,1H,2H,2H-perfluorodecyl acrylate (Aldrich, 97%)
- Initiator: di-t-butyl peroxide (Aldrich, 98%)
- Average supply flow rate of initiator: 0.26 sccm
- Average supply flow rate of monomer: 0.425 sccm
- Filament temperature: 140°C
- Pressure inside the reactor chamber: 80 mTorr
- Surface temperature of the mounting unit (silicon wafer) in the reactor: 38°C

### <Experimental Example 1>

### (1) X-ray Photoelectron Spectroscopy

Elemental analysis of the particle surfaces was performed using X-ray photoelectron spectroscopy (XPS) (Multilab 2000, Thermo) for the silicon particles before and after formation of the polymer thin film. The results are shown in Table 1.

**[Table 1]**

| Silicon Particle Diameter | | Carbon | Fluorine | Oxygen | Silicon |
|---|---|---|---|---|---|
| 20 µm | Before Formation of Polymer Thin Film | 42.46 | 0 | 24.18 | 33.36 |
| | After Formation of Polymer Thin Film | 20.34 | 21.79 | 18.2 | 39.67 |
| 2 µm | Before Formation of Polymer Thin Film | 24.82 | 0.3 | 25.01 | 49.87 |
| | After Formation of Polymer Thin Film | 25.36 | 21.8 | 17.18 | 35.66 |

As shown in Table 1, fluorine was hardly detected on the surface of the silicon particles before the formation of the polymer thin film, but after forming the polymer thin film on the silicon particles by the preparation method of the present invention, a significant amount of fluorine was detected. Accordingly, it can be seen that a silicon-polymer composite in which a fluorine-containing polymer thin film is formed on the surface of silicon particles was successfully prepared by the preparation method of the present invention.

### (2) Water Dispersibility

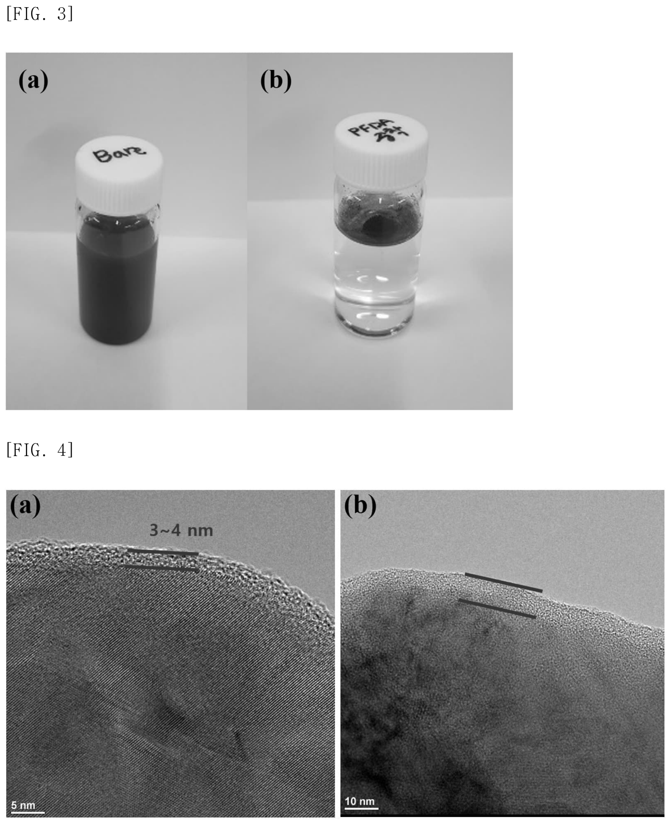

Each of the silicon particles before formation of the polymer thin film and the silicon-polymer composite obtained in Example 1 was separately weighed at 0.3 g and dispersed for 10 minutes by immersing in 10 mL of water. The results are shown in FIG. 3.

It can be seen that the silicon particles before formation of the polymer thin film exhibit hydrophilicity, as they appear to be sufficiently dispersed in water (FIG. 3A). In contrast, the silicon-polymer composite with the polymer thin film formed does not disperse in water but rather appears to form a layer on the water surface (FIG. 3B), indicating that its surface has been modified to be hydrophobic. This indicates that a silicon-polymer composite in which a fluorine-containing polymer thin film is formed on the surface of silicon particles was successfully prepared by the preparation method of the present invention.

### (3) Transmission Electron Microscopy-Energy Dispersive X-ray Spectroscopy (TEM-EDS)

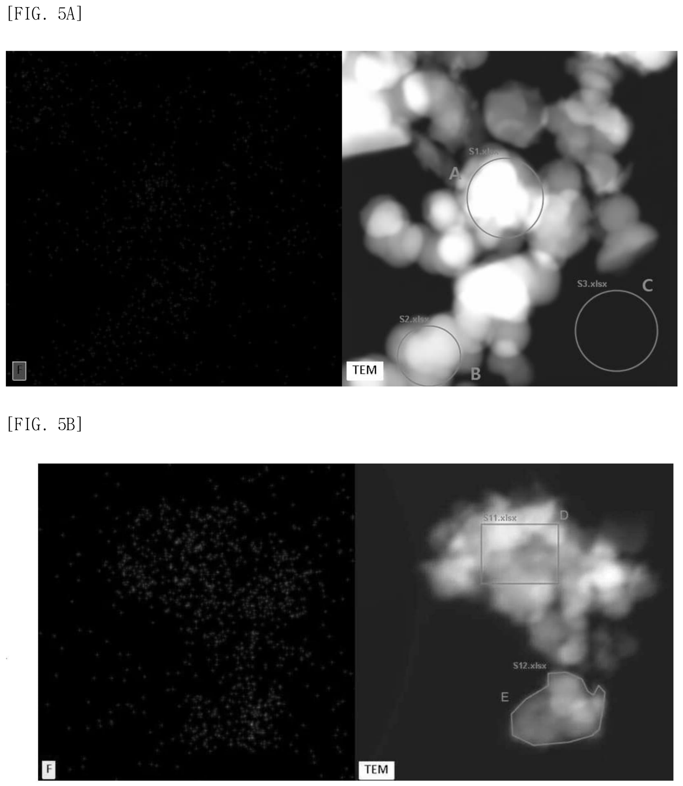

The silicon particles with an average particle diameter of 20 µm, on which the polymer thin film had been formed, were observed using a transmission electron microscope (TEM) and an energy dispersive spectrometer (EDS) (Tecnai G2 F30 S-Twin, FEI Company). The TEM analysis results are shown in FIG. 4, and the EDS analysis results are shown in FIG. 5 and Tables 2 and 3.

**[Table 2]**

| | Atomic % | | | Average |
|---|---|---|---|---|
| | A | B | C | |
| Si | 87.87 | 92.26 | 2.33 | 68.30 |
| C | 6.79 | 3.47 | 92.82 | 23.66 |
| F | 1.29 | 0.59 | 0 | 1.16 |
| Al | 0.46 | 0 | 0 | 0.33 |
| 0 | 6.03 | 3.68 | 4.85 | 6.56 |

**[Table 3]**

| | Atomic % | |
|---|---|---|
| | D | E |
| F | 0.26 | 1.07 |
| C | 1.91 | 13.67 |
| Si | 97.83 | 85.26 |

As a result, it can be seen from the Bare silicon particles shown in FIG. 2 and the TEM image in FIG. 4 that the silicon-polymer composite obtained in Example 1 maintains its original shape without issues such as particle breakage, with a uniform thin film having a thickness of approximately 5 nm formed thereon. FIG. 5 and Tables 2 and 3 show the EDS analysis results for the regions where the silicon-polymer composite is present (indicated as areas A and B in FIG. 5A and areas D and E in FIG. 5B) and the region where the silicon-polymer composite is not present (indicated as area C in FIG. 5A). Fluorine, which is a component of the monomer, was detected in all of the regions where the silicon-polymer composite was present, whereas no fluorine was detected in the region where the silicon-polymer composite was not present. Therefore, it can be qualitatively confirmed that the silicon-polymer composite, in which a polymer thin film is formed on the surface of the silicon particles, was produced by the preparation method of the present invention.

### <Example 2>

A silicon-polymer composite was prepared in the same manner as in Example 1, except that the following conditions were changed to form a polymer thin film (pDMAMS) on the surface of the silicon particles.
- Non-porous silicon particles: average particle diameter of 20 µm (REC Silicon)
- Monomer: Dimethylaminomethyl styrene (Acros, 90%)
- Pressure inside the reactor chamber: 160 mTorr
- Surface temperature of the mounting unit (silicon wafer) in the reactor: 35°C

### <Experimental Example 2>

### (1) Transmission Electron Microscopy-Energy Dispersive X-ray Spectroscopy (TEM-EDS)

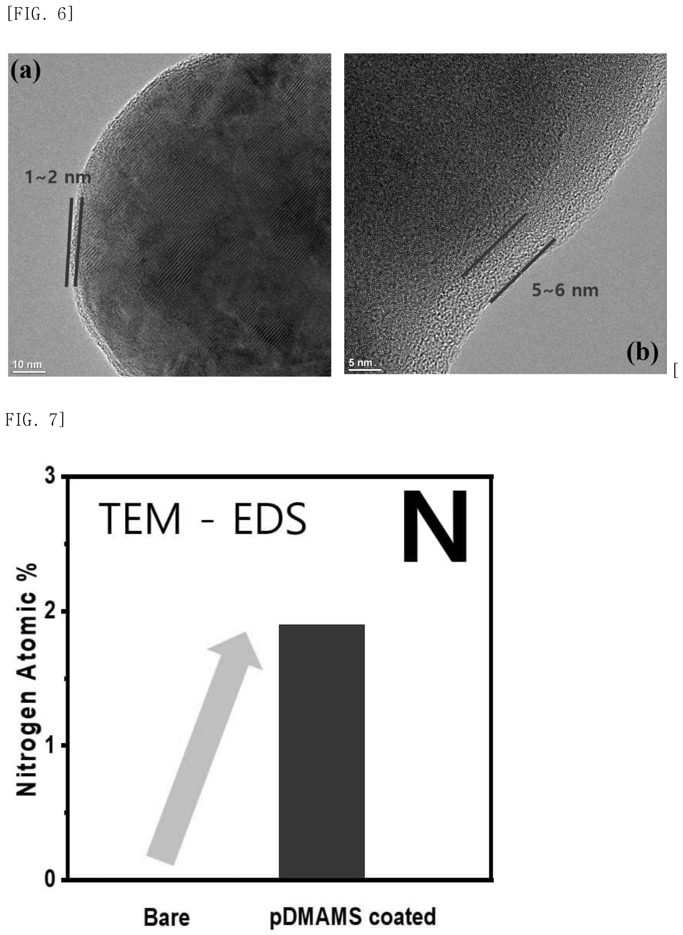

The silicon particles with an average particle diameter of 20 µm, on which the polymer thin film had been formed (Example 2), were observed using a transmission electron microscope (TEM) and an energy dispersive spectrometer (EDS) (Tecnai G2 F30 S-Twin, FEI Company). The TEM analysis results are shown in FIG. 6, and the EDS analysis results are shown in FIG. 7.

As a result, it was confirmed from the Bare silicon particles shown in FIG. 2 and the TEM image in FIG. 6 that the silicon-polymer composite obtained in Example 2 maintained its original shape, with a uniform thin film having a thickness of approximately 5 nm formed thereon.

In addition, as shown in FIG. 7, nitrogen atoms were identified in the silicon-polymer composite obtained in Example 2, indicating that the silicon-polymer composite with a polymer thin film formed on the surface of the silicon particles was qualitatively confirmed to have been produced by the preparation method of the present invention.

### <Example 3>

A silicon-polymer composite was prepared in the same manner as in Example 1, except that the following conditions were changed to form a polymer thin film (pDVB) on the surface of the silicon particles.
- Non-porous silicon particles: average particle diameter of 20 µm (REC Silicon)
- Monomer: Divinylbenzene (Aldrich, 80%)
- Pressure inside the reactor chamber: 450 mTorr
- Surface temperature of the mounting unit (silicon wafer) in the reactor: 23°C

### <Experimental Example 3>

### (1) Transmission Electron Microscopy Analysis

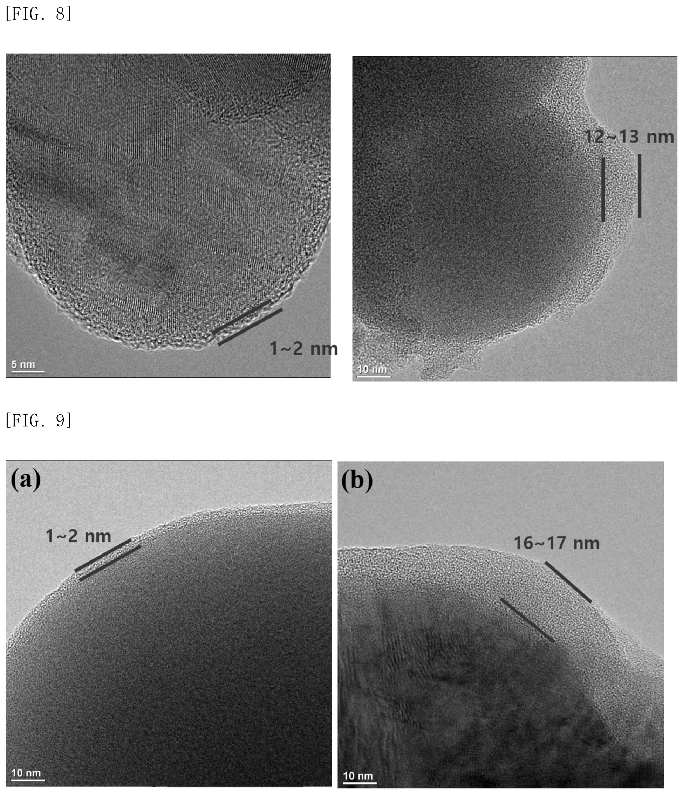

The silicon particles with an average particle diameter of 20 µm, on which the polymer thin film had been formed (Example 3), were observed using a transmission electron microscope (TEM). The TEM analysis results are shown in FIG. 8.

As a result, it was confirmed from the Bare silicon particles shown in FIG. 2 and the TEM image in FIG. 8 that the silicon-polymer composite obtained in Example 3 maintained its original shape, with a uniform thin film having a thickness of approximately 10 nm formed thereon.

### <Example 4>

A silicon-polymer composite was prepared in the same manner as in Example 1, except that the following conditions were changed to form a polymer thin film (pGMA) on the surface of the silicon particles.
- Non-porous silicon particles: average particle diameter of 20 µm (REC Silicon)
- Monomer: Glycidyl methacrylate (Alcrich, 97%)
- Pressure inside the reactor chamber: 300 mTorr
- Surface temperature of the mounting unit (silicon wafer) in the reactor: 30°C

### <Experimental Example 4>

### (1) Transmission Electron Microscopy Analysis

The silicon particles with an average particle diameter of 20 µm, on which the polymer thin film had been formed (Example 4), were observed using a transmission electron microscope (TEM). The TEM analysis results are shown in FIG. 9.

As a result, it was confirmed from the Bare silicon particles shown in FIG. 2 and the TEM image in FIG. 9 that the silicon-polymer composite obtained in Example 4 maintained its original shape, with a uniform thin film having a thickness of approximately 10 nm formed thereon.

### <Comparative Example 1>

### Preparation of Silicon-Polymer Composite

To prepare a silicon-polymer composite, 0.5 g of silicon powder with an average particle diameter of 20 µm was added to 10 mL of a toluene solvent in which poly(divinylbenzene) (pDVB) was dissolved at a concentration of 3 wt%. Liquid-phase coating was performed at 40 rpm and room temperature (25°C) for 120 minutes. The liquid-coated silicon powder was then taken out and dried at room temperature (25°C) for 12 hours to obtain a liquid-coated silicon-polymer composite.

### <Experimental Example 5>

### (1) Comparative Analysis Using Transmission Electron Microscopy

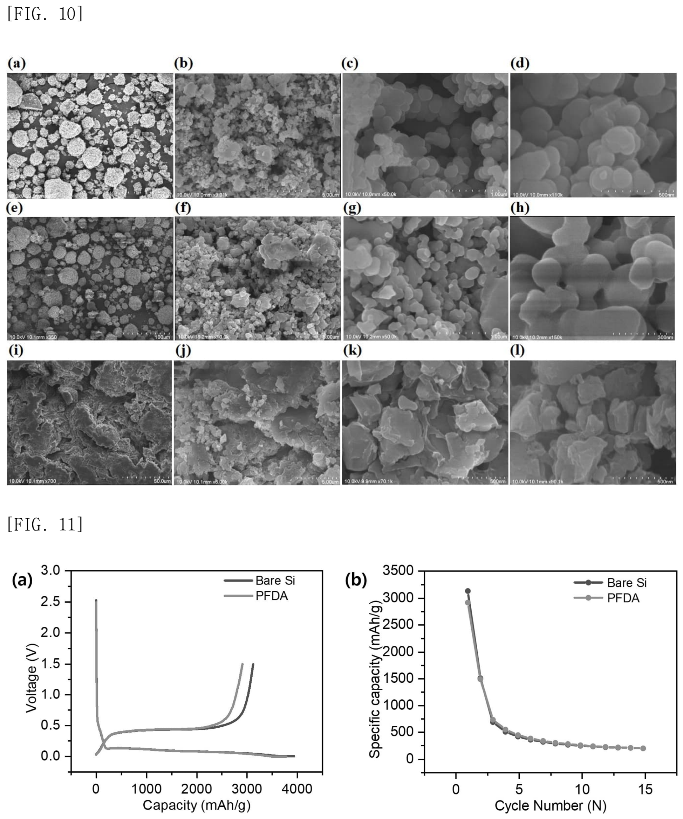

The Bare silicon particles (FIGs. 10A to 10D), the silicon-polymer composite obtained in Example 4 (FIGs. 10E to 10H), and the liquid-coated silicon-polymer composite obtained in Comparative Example 1 (FIGs. 10I to 10L) were observed using a transmission electron microscope (TEM). The TEM analysis results are shown in FIG. 10.

As a result, it was confirmed that, in the case of the silicon-polymer composite according to Example 4 (FIGs. 10E to 10H), a polymer coating with a uniform thickness was formed while maintaining the shape of the Bare silicon particles (FIGs. 10A to 10D).

In contrast, in the case of the liquid-coated silicon-polymer composite obtained in Comparative Example 1 (FIGs. 10I to 10L), it was confirmed that the shape of the Bare silicon particles (FIGs. 10A to 10D) was not maintained, and the polymer was coated in an amorphous form unrelated to the original shape of the Bare silicon particles.

Taken together, it can be concluded that the iCVD method must be used in order to coat a polymer with a uniform thickness on the surface of silicon particles.

### <Preparation Example 1>

A half coin cell was fabricated using the silicon-polymer composite prepared according to Example 1. The preparation conditions for the half coin cell are presented below.
- Composition (AM:CM:BM) = 8:1:1 (where AM, CM, and BM refer to the active material (silanized porous carbon support), the conductive material (Super P carbon black), and the binder (styrene-butadiene rubber/carboxymethyl cellulose in a 5:5 ratio), respectively.)
- Areal capacity (mAh/cm²): 4.5
- Electrolyte: 1.3 M LiPF₆ in EC/EMC/DMC (3:5:2 by volume), with 10% FEC, 0.2% LiBF₄ , 0.5% VC, and 1% PS (where EC, EMC, DMC, FEC, VC, and PS refer to ethylene carbonate, ethyl methyl carbonate, dimethyl carbonate, fluoroethylene carbonate, vinylene carbonate, and propanesultone, respectively).

### <Experimental Example 6>

### (1) Electrochemical Evaluation

The lithium secondary battery fabricated according to Preparation Example 1 was evaluated under the following conditions for initial charge/discharge efficiency, initial Coulombic efficiency (ICE), and capacity retention at the 14th cycle. The results are shown in Table 4 and FIG. 11.
- Cut-off voltage (V): Formation 0.005-1.5, Cycling test 0.005-1.5
- C-rate (C): Formation 0.1-0.1, CV cut-off at 0.01C from 0.005 V

**[Table 4]**

| | Charge capacity (mAh/g) | Discharge capacity (mAh/g) | ICE (%) | 14^{th} cycle capacity retention (%) |
|---|---|---|---|---|
| Application of Bare Si | 3935.9 | 3123.0 | 79.3 | 5.7 |
| Application of Example 1 | 3784.9 | 2909.5 | 76.9 | 6.3 |

As a result, it can be seen from Table 4 and FIG. 11 that, while the initial discharge efficiency and ICE were at similar levels, the capacity retention was improved. Specifically, in the case of Preparation Example 1, compared to the Bare Si application, it achieved a significant improvement of more than 10% in capacity retention in terms of relative ratio, while minimizing the reduction in charge/discharge capacity typically caused by coating a given material on the surface of Bare Si.

Although exemplary embodiments of the present invention have been described above, the scope of the present invention is not limited to the embodiments set forth herein. Those skilled in the art who understand the spirit of the present invention may readily propose other embodiments by adding, modifying, deleting, or supplementing components within the scope of the present invention, and such embodiments should also be regarded as falling within the scope of the present invention.

## Claims

1. A method for preparing a silicon-polymer composite, the method comprising:
forming a polymer thin film on surfaces of silicon particles by initiator-based chemical vapor deposition (iCVD).

2. The method of claim 1,
wherein the forming a polymer thin film comprises:
(1) supplying silicon particles into a reactor;
(2) supplying a monomer and an initiator into the reactor in which the silicon particles have been supplied; and
(3) forming the polymer thin film on surfaces of the silicon particles by polymerizing the monomer through activation of the initiator.

3. The method of claim 1, wherein the silicon particles are non-porous silicon particles.

4. The method of claim 1, wherein the silicon particles have an average particle diameter in the range of 10 nm to 50 µm.

5. The method of claim 1, wherein the polymer thin film has a thickness in the range of 1 nm to 10 µm.

6. The method of claim 2,
wherein, in step (2),
the monomer is supplied at a flow rate in the range of 0.1 sccm to 10 sccm, and
the initiator is supplied at a flow rate in the range of 0.1 sccm to 5 sccm.

7. The method of claim 2,
wherein the initiator is activated through predetermined heat treatment, and
the heat treatment is performed at a temperature in the range of 135°C to 350°C .

8. The method of claim 2, wherein step (3) is performed under a vacuum at a pressure in the range of 50 to 1,000 mTorr for a duration of 10 minutes to 6 hours.

9. The method of claim 1, further comprising forming a carbon thin film on the surface of the polymer thin film after forming the polymer thin film.

10. The method of claim 9, wherein the carbon thin film has a thickness in the range of 1 nm to 1 µm.

11. A silicon-polymer composite prepared by the method according to any one of claims 1 to 10.

12. An anode active material comprising:
the silicon-polymer composite according to claim 11; and
a carbon-based anode material.

13. An all-solid-state battery comprising a solid electrolyte interphase (SEI) layer that comprises the silicon-polymer composite according to claim 11.
